# EUROPEAN PATENT APPLICATION

(11) **EP 4 851 643 A1**
(43) Date of publication of application: **09.12.2026**
(21) Application number: 25792760.8
(22) Date of filing: 26.09.2025
(51) Int. Cl.: G01R 31/28, G01R 31/34, B60H 1/00

(54) **DETECTION METHOD AND APPARATUS FOR HIGH-VOLTAGE INTERLOCK FAULT**

(30) Priority: 11.04.2025 CN 202510451768
(71) Applicant: Chongqing Changan Automobile Co., Ltd., Chongqing 400023 (CN)
(72) Inventor: YI, Quanxiu, Chongqing 400023 (CN); LIU, Jun, Chongqing 400023 (CN); YU, Binbin, Chongqing 400023 (CN); YOU, Hongyi, Chongqing 400023 (CN)
(74) Representative: Groth & Co. KB
(86) International application number: PCT/CN2025/124267
(87) International publication number: WO 2026/214056

(57) **Abstract**

The present invention relates to a method and an apparatus for detecting high-voltage interlock faults, and the method and apparatus are applied to an air conditioning control system. The air conditioning control system includes an air conditioning controller and an air conditioning compressor motor; a midpoint of each phase bridge leg in three-phase bridge legs of the air conditioning controller is respectively connected to a different phase of the air conditioning compressor motor; each phase bridge leg includes an upper bridge leg switching transistor and a lower bridge leg switching transistor. The method includes: controlling each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and determining whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

## Description

### TECHNICAL FIELD

The present invention relates to the technical field of vehicles, in particular to a method and an apparatus for detecting high-voltage interlock faults.

### BACKGROUND

With the continuous development of new energy technologies, high-voltage safety issues are of crucial importance in the design of new energy vehicles. To reduce the safety hazards of high-voltage systems, low-voltage circuits are typically used at present to monitor the status of high-voltage components, wires, and connectors, and to monitor the on-off status between various high-voltage components of electric vehicles, thereby ensuring the integrity and continuity of a high-voltage system circuit. This method is called high-voltage interlock, also known as hard-wired interlock.

However, at present, after long-term operation, low-voltage interlock detection terminals configured to detect high-voltage interlock signals may experience problems such as corrosion, oxidation, terminal deformation, and pin withdrawal. Alternatively, when a vehicle is driving under harsh working conditions, large vibration may lead to momentary interruptions in high-voltage interlock signals and result in false alarms of high-voltage interlock faults by an entire vehicle. Moreover, a method of adding a low-voltage circuit leads to an increase in low-voltage wiring harnesses, low-voltage connectors, or detection chips, thereby increasing the system cost. In addition, when monitoring an interlock fault in a high-voltage component, since the low-voltage circuit determines whether a high-voltage system is abnormal by detecting the on-off status of components such as high-voltage connectors and wires, it is difficult to pinpoint specific components, and it is impossible to determine the specific location of the interlock fault.

### SUMMARY OF THE INVENTION

In view of this, the present invention provides a method and an apparatus for detecting high-voltage interlock faults.

According to a first aspect of the present invention, the present invention provides a method for detecting high-voltage interlock faults, and the method is applied to an air conditioning control system. The air conditioning control system includes an air conditioning controller and an air conditioning compressor motor; a midpoint of each phase bridge leg in three-phase bridge legs of the air conditioning controller is respectively connected to a different phase of the air conditioning compressor motor; each phase bridge leg includes an upper bridge leg switching transistor and a lower bridge leg switching transistor; and the method includes:
controlling each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and each of the first voltage-dividing resistors is connected to a different bridge leg switching transistor in the first switching transistor array; and determining whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

In a possible implementation, the determining whether a high-voltage interlock fault has occurred in a motor phase corresponding to each of the first voltage-dividing resistors according to a comparison result between the first voltage and a voltage threshold includes: when the first voltage applied across the first voltage-dividing resistor is less than the voltage threshold, determining that a high-voltage interlock fault has occurred in the motor phase corresponding to the first voltage-dividing resistor.

In a possible implementation, the determining whether a high-voltage interlock fault has occurred in a motor phase corresponding to each of the first voltage-dividing resistors according to a comparison result between the first voltage and a voltage threshold includes:
when the first voltage applied across the first voltage-dividing resistor is less than the voltage threshold, controlling again each bridge leg switching transistor in the first switching transistor array in the three-phase bridge legs of the air conditioning controller to be turned on, such that a second voltage is applied across each of the first voltage-dividing resistors to detect the high-voltage interlock faults;
when both the first voltage and the second voltage are less than the voltage threshold, determining that a high-voltage interlock fault has occurred in the motor phase corresponding to the first voltage-dividing resistor; and
when the first voltage is less than the voltage threshold and the second voltage is not less than the voltage threshold, determining that no high-voltage interlock fault has occurred in the motor phase corresponding to the first voltage-dividing resistor.

In a possible implementation, the controlling each bridge leg switching transistor in a first switching transistor array in the three-phase bridge legs of the air conditioning controller to be turned on includes: at a first moment, controlling the bridge leg switching transistors in the first switching transistor array that are not connected to the first voltage-dividing resistor to be turned on; and at a second moment, controlling the bridge leg switching transistors in the first switching transistor array that are connected to the first voltage-dividing resistor to be turned on.

In a possible implementation, the air conditioning control system further includes a heating controller and a heating resistor; and the method further includes:
controlling each switching transistor in a second switching transistor array of the heating controller to be turned on, wherein each switching transistor in the second switching transistor array is configured to detect high-voltage interlock faults, such that a third voltage is applied across each second voltage-dividing resistor to detect high-voltage interlock faults, wherein each of the second voltage-dividing resistors is connected to a different switching transistor in the second switching transistor array;
determining whether a high-voltage interlock fault has occurred in a phase corresponding to each of the second voltage-dividing resistors according to a comparison result between a third voltage applied across the second voltage-dividing resistor and the voltage threshold, wherein the phase corresponding to the second voltage-dividing resistor is one phase of the heating resistor; and
when the third voltage is less than the voltage threshold, determining that a high-voltage interlock fault has occurred in the phase corresponding to the second voltage-dividing resistor.

In a possible implementation, the second switching transistor array includes at least two switching transistors, and the controlling each switching transistor in the second switching transistor array of the heating controller to be turned on includes: at the second moment, controlling at least two switching transistors of the heating controller to be turned on, wherein the at least two switching transistors are configured to detect high-voltage interlock faults.

In a possible implementation, the method further includes: when a high-voltage interlock fault has occurred in a target phase, obtaining a specific location of the high-voltage interlock fault, wherein the target phase includes the motor phase corresponding to the first voltage-dividing resistor and/or the phase corresponding to the second voltage-dividing resistor; and determining a high-voltage interlock fault handling strategy corresponding to the high-voltage interlock fault location based on the high-voltage interlock fault location.

In a possible implementation, the determining a high-voltage interlock fault handling strategy corresponding to the high-voltage interlock fault location based on the high-voltage interlock fault location includes: if the high-voltage interlock fault location is the motor phase corresponding to the first voltage-dividing resistor, the determining the high-voltage interlock fault handling strategy corresponding to the motor phase includes: controlling a high-voltage system of an entire vehicle to be powered on, turning off each switching transistor of the three-phase bridge legs of the air conditioning controller, limiting the power of the air conditioning controller to a first preset value, controlling a system fault indicator light of a first target color on an instrument panel to be turned on, and controlling a display module to give a first text reminder; and if the high-voltage interlock fault location is the phase corresponding to the second voltage-dividing resistor, the determining the high-voltage interlock fault handling strategy corresponding to the target phase includes: controlling a high-voltage system of an entire vehicle to be powered on, turning off each switching transistor of the heating controller, limiting the power of the heating controller to a second preset value, controlling a system fault indicator light of a second target color on an instrument panel to be turned on, and controlling the display module to give a second text reminder.

According to a second aspect of the present invention, the present invention provides an apparatus for detecting high-voltage interlock faults, wherein the apparatus is applied to an air conditioning control system; the air conditioning control system includes an air conditioning controller and an air conditioning compressor motor; a midpoint of each phase bridge leg in the three-phase bridge legs of the air conditioning controller is respectively connected to a different phase of the air conditioning compressor motor; each phase bridge leg includes an upper bridge leg switching transistor and a lower bridge leg switching transistor; and the apparatus includes:
a switching transistor control module configured to control each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and each of the first voltage-dividing resistors is connected to a different bridge leg switching transistor in the first switching transistor array; and
a fault determination module configured to determine whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

In a third aspect, the present invention provides a computer device, including: a memory and a processor, wherein the memory and the processor are communicatively connected to each other; computer instructions are stored in the memory; and the processor executes the method for detecting high-voltage interlock faults according to the first aspect mentioned above or any of its corresponding embodiments through executing the computer instructions.

In a fourth aspect, the present invention provides a vehicle, including: a memory and a processor, wherein the memory and the processor are communicatively connected to each other; computer instructions are stored in the memory; and the processor executes the method for detecting high-voltage interlock faults according to the first aspect mentioned above or any of its corresponding embodiments through executing the computer instructions.

In a fifth aspect, the present invention provides a computer-readable storage medium, wherein computer instructions are stored in the computer-readable storage medium, and the computer instructions are used to enable a computer to execute the method for detecting high-voltage interlock faults according to the first aspect mentioned above or any of its corresponding embodiments.

In a sixth aspect, the present invention provides a computer program product, wherein the computer program product includes computer instructions, and the computer instructions are used to enable a computer to execute the method for detecting high-voltage interlock faults according to the first aspect mentioned above or any of its corresponding embodiments.

In the present invention, each bridge leg switching transistor in the first switching transistor array in the three-phase bridge legs of the air conditioning controller is controlled to be turned on, then the first voltage applied across each first voltage-dividing resistor is collected, and the first voltage is compared with the voltage threshold to determine a comparison result corresponding to each first voltage-dividing resistor, and whether a high-voltage interlock fault has occurred in the motor phase corresponding to each first voltage-dividing resistor can be accurately determined according to the comparison result corresponding to each first voltage-dividing resistor.

Compared with the related art, in the present application, the circuit of the air conditioning control system itself is used, and whether a high-voltage interlock fault has occurred in the motor phase corresponding to each first voltage-dividing resistor is determined by adding voltage-dividing resistors. There is no need to add low-voltage interlock detection terminals for detecting high-voltage interlock signals, thereby avoiding problems such as corrosion, oxidation, terminal deformation, and pin withdrawal of the low-voltage interlock detection terminals for detecting the high-voltage interlock signals after long-term operation, and avoiding the following problem: when a vehicle is driving under harsh working conditions, large vibration may lead to momentary interruptions in high-voltage interlock signals and result in false alarms of high-voltage interlock faults by an entire vehicle. Moreover, the elimination of additional low-voltage circuits reduces system costs.

In addition, since the low-voltage circuit determines whether a high-voltage system is abnormal by monitoring the on-off status of components such as high-voltage connectors and wires, it is difficult to pinpoint specific components, and it is impossible to determine the specific location of the interlock fault. In the present invention, whether a high-voltage interlock fault has occurred in each first voltage-dividing resistor can be accurately located according to the comparison result of the voltage of each first voltage-dividing resistor, and the specific location of the high-voltage interlock fault can be further accurately determined.

### BRIEF DESCRIPTION OF THE DRAWINGS

To more clearly illustrate the specific embodiments of the present invention or the technical solutions in the prior art, a brief introduction of the accompanying drawings required for describing the specific embodiments or the prior art will be given below. Obviously, the accompanying drawings in the following description are some embodiments of the present invention, and for those skilled in the art, other accompanying drawings can also be obtained based on these drawings without any creative effort.
FIG. 1 is a block diagram of an air conditioning control system provided according to an embodiment of the present invention;
FIG. 2 is a flow diagram of a method for detecting high-voltage interlock faults provided according to an embodiment of the present invention;
FIG. 3 is a block diagram of another air conditioning control system provided according to an embodiment of the present invention;
FIG. 4 is a block diagram of another air conditioning control system provided according to an embodiment of the present invention;
FIG. 5 is a block diagram of still another air conditioning control system provided according to an embodiment of the present invention;
FIG. 6 is a block diagram of still another air conditioning control system provided according to an embodiment of the present invention;
FIG. 7 is a timing diagram of the conduction of a switching transistor used for detecting high-voltage interlock faults provided according to an embodiment of the present invention;
FIG. 8 is a flow diagram of another method for detecting high-voltage interlock faults provided according to an embodiment of the present invention;
FIG. 9 is a schematic diagram of a hardware structure of a computer device provided according to an embodiment of the present invention.

### DETAILED DESCRIPTION OF SPECIFIC EMBODIMENTS

Embodiments of the present invention will be described below with reference to the accompanying drawings and preferred embodiments. Those skilled in the art can easily understand other advantages and effects of the present invention from the content disclosed in this specification. The present invention can also be implemented or applied through other different specific embodiments, and various details in this specification can also be modified or changed based on different viewpoints and applications without departing from the spirit of the present invention. It should be understood that the preferred embodiments are merely for the purpose of illustrating the present invention, rather than limiting the protection scope of the present invention.

It should be noted that the diagrams provided in the following embodiments only illustrate basic concepts of the present invention in a schematic manner. Therefore, only the components related to the present invention are shown in the drawings, rather than being drawn according to the number, shape, and size of the components in actual implementation. In actual implementation, the types, quantities, and proportions of each component can be arbitrarily changed, and the component layout pattern may also be more complex.

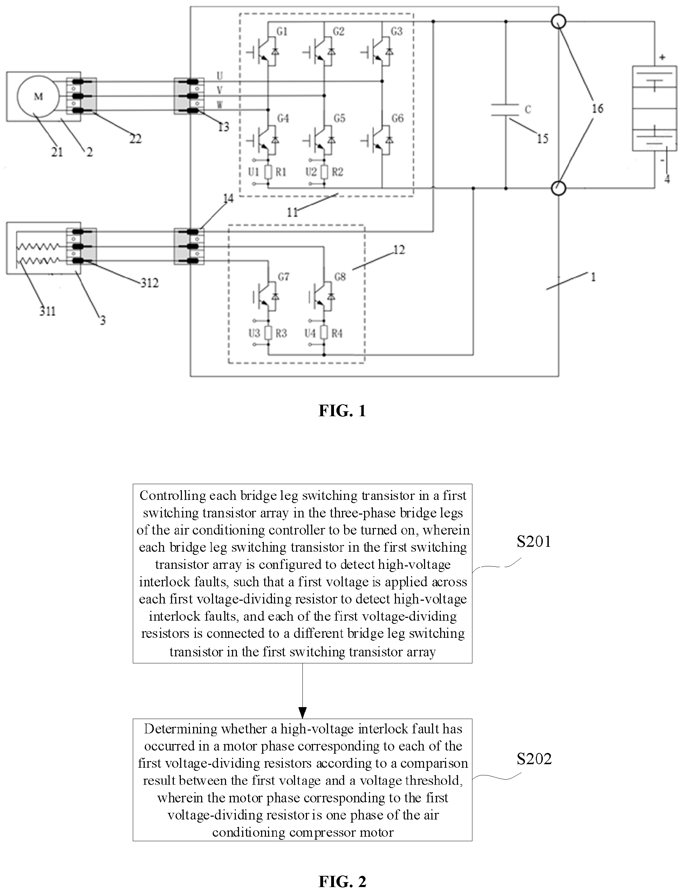

Please refer to FIG. 1 which is a block diagram of an air conditioning control system provided according to an embodiment of the present invention. The air conditioning control system includes an air conditioning compressor (ACP) 2, a heating resistor 3, an air conditioning control module 1, and a high-voltage power battery 4, wherein the air conditioning control module 1 can be configured to independently integrate functional circuits of the air conditioning compressor 2 and the heating resistor 3 to achieve the purpose of controlling the air conditioning control system.

The air conditioning control module 1 may include an air conditioning controller 11, a heating controller 12, an ACP power distribution connector 13, a positive temperature coefficient (PTC) thermistor power distribution connector (i.e., a PTC power distribution connector 14), a bus capacitor 15, and a bus IPT (Inductive Power Transfer) interface 16. A positive terminal and a negative terminal of the bus IPT interface 16 are respectively connected to the high-voltage power battery 4. The air conditioning compressor 2 may include an air conditioning motor 21 and an air conditioning compressor connector 22, wherein the air conditioning motor 21 is a three-phase motor, and a U-phase, a V-phase, and a W-phase of the air conditioning motor 21 can be connected to the air conditioning compressor connector 22.

Upper ends of the three-phase bridge legs of the air conditioning controller 11 can be connected to the positive terminal of a DC bus; lower ends of the three-phase bridge legs of the air conditioning controller 11 can be connected to the negative terminal of the DC bus; and midpoints of the three-phase bridge legs of the air conditioning controller 11 are respectively connected to the ACP power distribution connector 13, such that the midpoint of each phase bridge leg in the three-phase bridge legs of the air conditioning controller 11 is respectively connected to a different phase of the air conditioning compressor 2. That is, a U phase of the three-phase bridge legs is connected to a U phase of the air conditioning motor 21; a V phase of the three-phase bridge legs is connected to a V phase of the air conditioning motor 21, and a W phase of the three-phase bridge legs is connected to a W phase of the air conditioning motor 21.

The air conditioning controller 11 can include a plurality of bridge leg switching transistors, and the plurality of bridge leg switching transistors can be respectively a switching transistor G1, a switching transistor G2, a switching transistor G3, a switching transistor G4, a switching transistor G5, and a switching transistor G6, wherein the switching transistor G1 and the switching transistor G4 form a first bridge leg of the air conditioning controller 11; the switching transistor G2 and the switching transistor G5 form a second bridge leg of the air conditioning controller 11, and the switching transistor G3 and the switching transistor G6 form a third bridge leg of the air conditioning controller 11. The switching transistors can be field-effect tubes or other types of power electronic components, which is not specifically limited herein.

It should be noted that the switching transistor connected to the positive terminal of the DC bus can serve as an upper bridge leg switching transistor, and the switching transistor connected to the negative terminal of the DC bus can serve as a lower bridge leg switching transistor.

The air conditioning controller 11 may also include voltage-dividing resistors. Regarding the air conditioning controller 11, the voltage-dividing resistors configured to detect high-voltage interlock faults may include a voltage-dividing resistor R1 and a voltage-dividing resistor R2. The corresponding sampling voltages may include sampling voltage U1 and sampling voltage U2. The sampling voltage U1 is obtained by sampling the voltage across the voltage-dividing resistor R1, and the sampling voltage U2 is obtained by sampling the voltage across the voltage-dividing resistor R2. The voltage-dividing resistor R1 and the voltage-dividing resistor R2 may be respectively connected to the switching transistors of the air conditioning controller 11. The switching transistors connected to the voltage-dividing resistor R1 and the voltage-dividing resistor R2 may not belong to the same bridge leg. For example, the voltage-dividing resistor R1 is connected to the switching transistor G1, and the voltage-dividing resistor R2 cannot be connected to the switching transistor G4. In this embodiment, one end of the voltage-dividing resistor R1 may be connected to the switching transistor G4, and the other end of the voltage-dividing resistor R1 is connected to the negative terminal of the DC bus. One end of the voltage-dividing resistor R2 is connected to the switching transistor G5, and the other end of the voltage-dividing resistor R2 is connected to the negative terminal of the DC bus.

As an example, one end of the voltage-dividing resistor R1 can be connected to the switching transistor G1, and the other end of the voltage-dividing resistor R1 can be connected to the positive terminal of the DC bus. One end of the voltage-dividing resistor R2 can be connected to the switching transistor G2, and the other end of the voltage-dividing resistor R2 can be connected to the positive terminal of the DC bus.

As an example, one end of the voltage-dividing resistor R1 can be connected to the switching transistor G1, and the other end of the voltage-dividing resistor R1 can be connected to the positive terminal of the DC bus. One end of the voltage-dividing resistor R2 is connected to the switching transistor G5, and the other end of the voltage-dividing resistor R2 is connected to the negative terminal of the DC bus.

The heating resistor 3 includes a heating resistor 311 and a heating resistor connector 312. One end of the heating resistor 311 is connected to the heating resistor connector 312, and the other end of the heating resistor 311 is connected to the positive terminal of the DC bus. One end of the heating resistor connector 312 is connected to the PTC power distribution connector 14, and the other end of the heating resistor connector 312 is connected to the heating resistor 311. An input end of the heating controller 12 can be connected to the positive terminal and the negative terminal of the DC bus, and an output end of the heating controller 12 can be connected to the PTC power distribution connector 14. One end of the PTC power distribution connector 14 is connected to the heating controller 12, and the other end of the PTC power distribution connector 14 is connected to the heating resistor connector 312.

The heating controller 12 includes a switching transistor G7, a switching transistor G8, a voltage-dividing resistor R3, and a voltage-dividing resistor R4, wherein the voltage-dividing resistor R3 and the voltage-dividing resistor R4 can be connected to different phases of the heating resistor 3.

In this embodiment, one end of the switching transistor G7 is connected to the PTC power distribution connector 14, and the other end of the switching transistor G7 is connected to the voltage-dividing resistor R3. One end of the voltage-dividing resistor R3 is connected to the switching transistor G7, and the other end of the voltage-dividing resistor R3 is connected to the negative terminal of the DC bus. The sampling voltage U3 is obtained by sampling the voltage across the voltage-dividing resistor R3. One end of the switching transistor G8 is connected to the PTC power distribution connector 14, and the other end of the switching transistor G8 is connected to the voltage-dividing resistor R4. One end of the voltage-dividing resistor R4 is connected to the switching transistor G4, and the other end of the voltage-dividing resistor R4 is connected to the negative terminal of the DC bus. The sampling voltage U4 is obtained by sampling the voltage across the voltage-dividing resistor R4.

As an example, one end of the voltage-dividing resistor R3 is connected to the switching transistor G7, and the other end of the voltage-dividing resistor R3 is connected to the PTC power distribution connector 14. One end of the voltage-dividing resistor R4 is connected to the switching transistor G8, and the other end of the voltage-dividing resistor R4 is connected to the negative terminal of the DC bus.

According to an embodiment of the present invention, an embodiment of a method for detecting high-voltage interlock faults is provided. It should be noted that the steps shown in the flowcharts of the accompanying drawings can be executed in a computer system such as a set of computer-executable instructions. Moreover, although a logical order is shown in the flowcharts, in some cases, the steps shown or described may be executed in an order different from that presented herein.

This embodiment provides a method for detecting high-voltage interlock faults, and the method can be used in the above air conditioning control system, etc. FIG. 2 is a flow diagram of a method for detecting high-voltage interlock faults provided according to an embodiment of the present invention. As shown in FIG. 2, the process includes the following steps:
Step S201: controlling each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and each of the first voltage-dividing resistors is connected to a different bridge leg switching transistor in the first switching transistor array.

The first switching transistor array can indicate the switching transistors configured to detect high-voltage interlock faults in all the bridge leg switching transistors. Herein, the number of switching transistors can be 2, 3, etc., which is not specifically limited herein. The first voltage-dividing resistor can indicate the voltage-dividing resistor configured to detect high-voltage interlock faults. After the first switching transistor array is determined, each bridge leg switching transistor in the first switching transistor array is closed, such that each bridge leg switching transistor in the first switching transistor array is turned on, and the current generated by a high-voltage power battery passes through each bridge leg switching transistor in the first switching transistor array and flows to the first voltage-dividing resistor, and then it is determined that the first voltage of the first voltage-dividing resistor is generated across each first voltage-dividing resistor, wherein the first voltage is used for detecting high-voltage interlock faults.

As an example, referring to FIG. 1, the number of bridge leg switching transistors in the first switching transistor array can be 3. The switching transistor G3, the switching transistor G4 and the switching transistor G5 can be selected as the first switching transistor array. When the switching transistor G3, the switching transistor G4 and the switching transistor G5 are controlled to close, the high-voltage power battery can generate current, and the current can flow through a positive terminal of the high-voltage power battery, the switching transistor G3, the switching transistor G4, the switching transistor G5, the voltage-dividing resistor R1, and the voltage-dividing resistor R2. When the current flows through the voltage-dividing resistor R1, the voltage-dividing resistor R1 can generate a voltage which is used for detecting high-voltage interlock faults. When the current flows through the voltage-dividing resistor R2, the voltage-dividing resistor R2 can generate a voltage used for detecting high-voltage interlock faults. If a fault only occurs in one of the V phase or the W phase, it can be determined that there is a problem with the circuit of the faulty phase. For example, if a fault occurs in the V phase, it can be determined that there is a problem with the circuit of the V phase.

As an example, the number of switching transistors in the first switching transistor can be two. The switching transistor G3 and the switching transistor G5 can be selected as the first switching transistor array. The current can flow through the positive terminal of the high-voltage power battery, the switching transistor G3, the switching transistor G5, and the voltage-dividing resistor R2. When the current flows through the voltage-dividing resistor R2, the voltage-dividing resistor R2 can generate a voltage used for detecting high-voltage interlock faults. If the voltage of the voltage-dividing resistor R2 is less than the voltage threshold, it indicates that the circuit is incomplete, and it can be determined that a high-voltage interlock fault has occurred in the V phase.

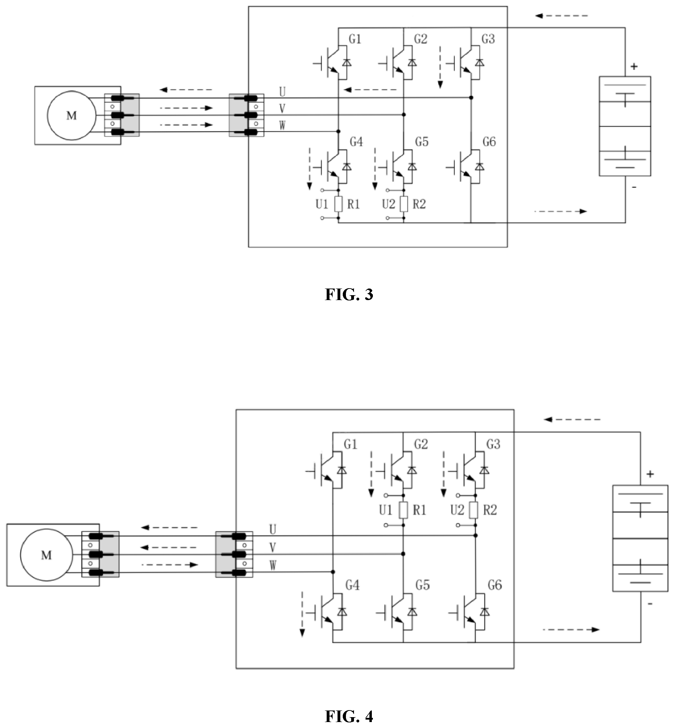

Please refer to FIG. 3 which is a block diagram of another air conditioning control system provided according to an embodiment of the present invention.

As shown in FIG. 3, the bridge leg switching transistors in the first switching transistor array can be selected as the switching transistor G3, the switching transistor G4 and the switching transistor G5. The flow direction of the current in the circuit of the air conditioning compressor is shown by a dotted arrow in FIG. 3. The current flows out from the positive terminal of the high-voltage power battery, passes through the switching transistor G1 of the air conditioning controller, and flows through the ACP power distribution connector, the air conditioning compressor connector, and the U phase of the air conditioning motor. After flowing through the U phase and the V phase of the air conditioning motor respectively, the current then flows through the switching transistor G4 and the voltage-dividing resistor R1 of the air conditioning controller, as well as the switching transistor G5 and the voltage-dividing resistor R2 of the air conditioning controller respectively, and finally flows to the negative terminal of the high-voltage power battery. In this process, if the circuit connection is complete, the current will flow through both the voltage-dividing resistor R1 and the voltage-dividing resistor R2. The voltage across the voltage-dividing resistor R1 can be obtained through the sampling voltage U1; and the voltage across the voltage-dividing resistor R2 can be obtained through the sampling voltage U2.

Please refer to FIG. 4 which is a block diagram of another air conditioning control system according to an embodiment of the present invention.

As shown in FIG. 4, the bridge leg switching transistors in the first switching transistor array can be selected as the switching transistor G2, the switching transistor G3 and the switching transistor G4. The flow direction of the current in the circuit of the air conditioning compressor is shown by a dotted arrow in FIG. 4. The current flows out from the positive terminal of the high-voltage power battery, passes through the switching transistor G2 and the voltage-dividing resistor R1 of the air conditioning controller, as well as the switching transistor G3 and the voltage-dividing resistor R2 of the air conditioning controller respectively, and passes through the ACP power distribution connector, the air conditioning compressor connector, and the U phase and the V phase of the air conditioning motor. After flowing through the W phase of the air conditioning motor, the current flows through the switching transistor G4 of the air conditioning controller, and finally flows to the negative terminal of the high-voltage power battery. In this process, if the circuit connection is complete, the current will flow through both the voltage-dividing resistor R1 and the voltage-dividing resistor R2. The voltage across the voltage-dividing resistor R1 can be obtained through the sampling voltage U1; and the voltage across the voltage-dividing resistor R2 can be obtained through the sampling voltage U2.

Step S202: determining whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

High-voltage interlock is a safety mechanism. Once an abnormality in circuit integrity is detected, such as looseness or disconnection of the high-voltage circuit, a high-voltage relay can be cut off to prevent leakage, arcing, and high-voltage electric shock injuries, thereby ensuring the safety of personnel and vehicles. High-voltage interlock faults can be caused by vibration, improper installation, or connector loosening after long-term use. In this embodiment, whether a high-voltage interlock fault has occurred in the motor phase corresponding to the first voltage-dividing resistor can be determined based on the comparison result between the voltage of the first voltage-dividing resistor and the voltage threshold.

The voltage threshold can indicate a critical point at which a high-voltage interlock fault occurs. The voltage threshold can be U5, U6, etc., which is not specifically limited herein. For each first voltage-dividing resistor, such as voltage-dividing resistor R1, voltage-dividing resistor R2, etc., the voltage of each first voltage-dividing resistor can be detected according to the sampling voltage, then the voltage of each first voltage-dividing resistor is compared with the voltage threshold to obtain a comparison result of each first voltage-dividing resistor, and finally whether a high-voltage interlock fault has occurred in the motor phase corresponding to each first voltage-dividing resistor is determined according to the comparison result of each first voltage-dividing resistor,.

In the method for detecting high-voltage interlock faults provided in this embodiment, each bridge leg switching transistor in the first switching transistor array in the three-phase bridge legs of the air conditioning controller is controlled to be turned on, then the first voltage applied across each first voltage-dividing resistor is collected, and the first voltage applied across each first voltage-dividing resistor is compared with the voltage threshold to determine a comparison result corresponding to each first voltage-dividing resistor, and whether a high-voltage interlock fault has occurred in the motor phase corresponding to each first voltage-dividing resistor can be accurately determined according to the comparison result corresponding to each first voltage-dividing resistor. Compared with the related technology, since the low-voltage circuit determines whether a high-voltage system is abnormal by monitoring the on-off status of components such as high-voltage connectors and wires, it is difficult to pinpoint specific components, and it is impossible to determine the specific location of the interlock fault. In the present invention, whether a high-voltage interlock fault has occurred in each first voltage-dividing resistor can be accurately located according to the comparison result of the voltage of each first voltage-dividing resistor, and the specific location of the high-voltage interlock fault can be further accurately determined.

In a possible implementation, the above step S202 includes: when the first voltage applied across the first voltage-dividing resistor is less than the voltage threshold, determining that a high-voltage interlock fault has occurred in the motor phase corresponding to the first voltage-dividing resistor, wherein the first voltage is used for detecting high-voltage interlock faults.

As can be seen from the above text, the voltage threshold can indicate a critical point at which a high-voltage interlock fault occurs. When the first voltage applied across the first voltage-dividing resistor is less than the voltage threshold, it is determined that a high-voltage interlock fault has occurred in the motor phase corresponding to the first voltage-dividing resistor, wherein the first voltage is used for detecting high-voltage interlock faults. When the first voltage applied across the first voltage-dividing resistor is not less than the voltage threshold, it is determined that no high-voltage interlock fault has occurred in the motor phase corresponding to the first voltage-dividing resistor, wherein the first voltage is used for detecting high-voltage interlock faults.

In the method for detecting high-voltage interlock faults provided in this embodiment, through setting a voltage threshold, it can be quickly and accurately determined that a high-voltage interlock fault may occur in the motor phase corresponding to the voltage-dividing resistor when the voltage across the voltage-dividing resistor is lower than the voltage threshold.

In a possible implementation, the above step S202 includes:
Step S2021: when the first voltage applied across the first voltage-dividing resistor is less than the voltage threshold, controlling again each bridge leg switching transistor in the first switching transistor array in the three-phase bridge legs of the air conditioning controller to be turned on, such that a second voltage is applied across each of the first voltage-dividing resistors to detect the high-voltage interlock faults.

In this embodiment, when the first voltage of the first voltage-dividing resistor is less than the voltage threshold, it is not directly determined that a high-voltage interlock fault has occurred in the motor phase corresponding to the first voltage-dividing resistor. Instead, it is necessary to control again each bridge leg switching transistor in the first switching transistor array in the three-phase bridge legs of the air conditioning controller to be turned on, so as to determine the second voltage applied across the first voltage-dividing resistor, wherein the second voltage is used for detecting high-voltage interlock faults.

For example, when the first voltage of the voltage-dividing resistor R1 is less than the voltage threshold, each bridge leg switching transistor in the first switching transistor array in the three-phase bridge legs of the air conditioning controller is controlled again to be turned on, and the second voltage of the voltage-dividing resistor R1 is determined again, wherein the first voltage is used for detecting high-voltage interlock faults.

For another example, when the first voltage of the voltage-dividing resistor R2 is less than the voltage threshold, each bridge leg switching transistor in the first switching transistor array in the three-phase bridge legs of the air conditioning controller is controlled again to be turned on, and the second voltage of the voltage-dividing resistor R2 is determined again.

Step S2022: when both the first voltage applied across the first voltage-dividing resistor and the second voltage of the first voltage-dividing resistor are less than the voltage threshold, determining that a high-voltage interlock fault has occurred in the motor phase corresponding to the first voltage-dividing resistor.

When the second voltage is also less than the voltage threshold, it is determined that a high-voltage interlock fault has occurred in the motor phase corresponding to the first voltage-dividing resistor.

In a possible implementation, the first detection of whether the first voltage is less than the voltage threshold can be used as a first condition, and the second detection of whether the second voltage is less than the voltage threshold can be used as a second condition. When the first voltage is detected to be less than the voltage threshold in the first detection, the second condition may be executed; if the second condition is that the second voltage is less than the voltage threshold, it is determined that a high-voltage interlock fault has occurred in the motor phase corresponding to the first voltage-dividing resistor. When the first voltage is detected to be greater than the voltage threshold in the first detection, there is no need to execute the second condition.

Step S2023: when the first voltage is less than the voltage threshold and the second voltage is not less than the voltage threshold, determining that no high-voltage interlock fault has occurred in the motor phase corresponding to the first voltage-dividing resistor.

As can be seen from the above, when the first voltage applied across the first voltage-dividing resistor is less than the voltage threshold, it is necessary to control again each bridge leg switching transistor in the first switching transistor array in the three-phase bridge legs of the air conditioning controller to be turned on, and determine the second voltage applied across each first voltage-dividing resistor. If the second voltage is not less than the voltage threshold, the circuit may have a voltage deviation during the first detection due to other factors. Therefore, it is determined that no high-voltage interlock fault has occurred in the motor phase corresponding to the first voltage-dividing resistor.

In the method for detecting high-voltage interlock faults provided in this embodiment, the first switching transistor array in the three-phase bridge legs of the air conditioning controller is controlled twice, and the first voltage and the second voltage are measured respectively, wherein the first switching transistor array is used for detecting high-voltage interlock faults. Only when both the first voltage and the second voltage measured twice for the same voltage-dividing resistor are less than the voltage threshold, it is determined that no high-voltage interlock fault has occurred in the motor phase corresponding to this voltage-dividing resistor, thereby reducing the possibility of false alarms or missed reports caused by errors or interference during a single measurement, and improving the accuracy of determining high-voltage interlock faults.

In a possible implementation, the controlling each bridge leg switching transistor in a first switching transistor array in the three-phase bridge legs of the air conditioning controller to be turned on in the above step S201 includes:
Step S2011: at a first moment, controlling the bridge leg switching transistors in the first switching transistor array that are not connected to the first voltage-dividing resistor to be turned on.
Step S2012: at a second moment, controlling the bridge leg switching transistors in the first switching transistor array that are connected to the first voltage-dividing resistor to be turned on.

The first moment can represent the moment when the bridge leg switching transistor that is not connected to the first voltage-dividing resistor is turned on. For example: at T1, the bridge leg switching transistor that is not connected to the first voltage-dividing resistor is closed.

The second moment can represent the moment when the bridge leg switching transistor that is connected to the first voltage-dividing resistor is turned on. For example, at T2, the bridge leg switching transistor that is connected to the first voltage-dividing resistor is closed.

As an example, referring to FIG. 1, the bridge leg switching transistor in the first switching transistor array that is not connected to the first voltage-dividing resistor can be the switching transistor G3, and the bridge leg switching transistors in the first switching transistor array that are connected to the first voltage-dividing resistor can be a switching transistor G4 and a switching transistor G5. The first moment can be earlier than the second moment, that is, the switching transistor G3 can be turned on first, and then the switching transistor G4 and the switching transistor G5 can be turned on.

In the method for detecting high-voltage interlock faults provided in this embodiment, the bridge leg switching transistors in the first switching transistor array that are not connected to the first voltage-dividing resistor and the bridge leg switching transistors that are connected to the first voltage-dividing resistor are respectively controlled to be turned on at different moments, so as to respectively obtain voltage information in two states. This time-sharing control method helps to reduce the interference caused by operating a plurality of switching transistors simultaneously and improve the accuracy of detection.

In a possible implementation, the air conditioning control system further includes a heating controller and a heating resistor. The above method further includes:
Step S301: controlling each switching transistor in a second switching transistor array of the heating controller to be turned on, wherein each switching transistor in the second switching transistor array is configured to detect high-voltage interlock faults, such that a third voltage is applied across each second voltage-dividing resistor to detect high-voltage interlock faults, wherein each of the second voltage-dividing resistors is connected to a different switching transistor in the second switching transistor array.

The second switching transistor array can indicate the switching transistors in the switching transistors of the heating resistor, wherein the transistors are configured to detect high-voltage interlock faults. The number of the switching transistors in the second switching transistor array can be 1, 2, etc., which is not specifically limited herein. By turning on the switching transistors in the second switching transistor array, a third voltage for detecting high-voltage interlock faults is generated across each second voltage-dividing resistor.

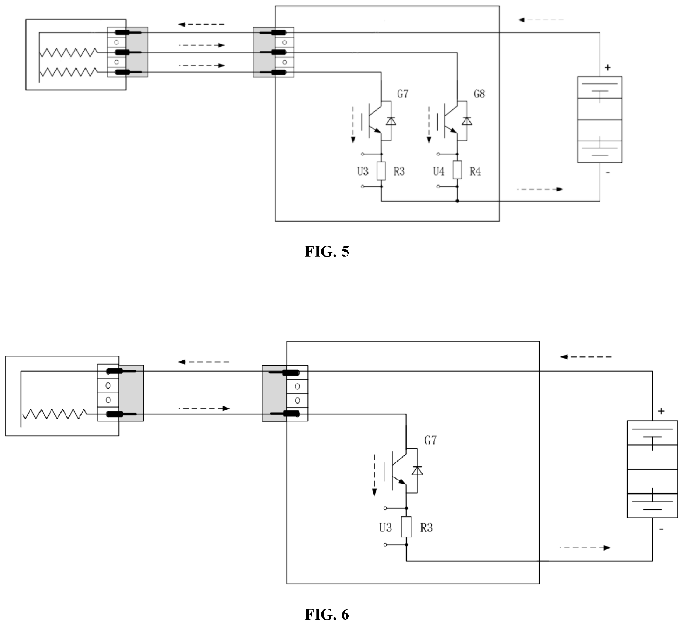

Please refer to FIG. 5 which is a block diagram of another air conditioning control system provided according to an embodiment of the present invention.

As shown in FIG. 5, when the number of the second switching transistor arrays is two, the second switching transistor array may include the switching transistor G7 and the switching transistor G8. One end of the switching transistor G7 is connected to the PTC power distribution connector, and the other end of the switching transistor G7 is connected to the voltage-dividing resistor R3. One end of the voltage-dividing resistor R3 is connected to the switching transistor G7, and the other end of the voltage-dividing resistor R3 is connected to the negative terminal of the DC bus. The sampling voltage U3 is obtained by sampling the voltage across the voltage-dividing resistor R3. One end of the switching transistor G8 is connected to the PTC power distribution connector, and the other end of the switching transistor G8 is connected to the voltage-dividing resistor R4. One end of the voltage-dividing resistor R4 is connected to the switching transistor G4, and the other end of the voltage-dividing resistor R4 is connected to the negative terminal of the DC bus. The sampling voltage U4 is obtained by sampling the voltage across the voltage-dividing resistor R4. The flow direction of the current of the heating resistance circuit is shown by a dotted arrow in FIG. 5. When the switching transistor G7 and the switching transistor G8 are turned on, the current flows out from the positive terminal of the high-voltage power battery, passes through the PTC power distribution connector, the heating resistance connector and one end of the heating resistor, and then flows through the switching transistor G7 and the voltage-dividing resistor R3 of the heating controller as well as the switching transistor G8 and the voltage-dividing resistor R4 of the heating controller respectively, and finally flows to the negative terminal of the high-voltage power battery. In this process, if the circuit connection is complete, current will flow through both the voltage-dividing resistor R3 and the voltage-dividing resistor R4, so the sampling voltage U3 and the sampling voltage U4 can be detected.

Please refer to FIG. 6 which is a block diagram of still another air conditioning control system provided according to an embodiment of the present invention.

As shown in FIG. 6, when the number of transistors in the second switching transistor array is 1, the second switching transistor array includes the switching transistor G7. One end of the switching transistor G7 is connected to the PTC power distribution connector, and the other end of the switching transistor G7 is connected to the voltage-dividing resistor R3. One end of the voltage-dividing resistor R3 is connected to the switching transistor G7, and the other end of the voltage-dividing resistor R3 is connected to the negative terminal of the DC bus. The sampling voltage U3 is obtained by sampling the voltage across the voltage-dividing resistor R3. The flow direction of the current in the circuit of the heating resistor is shown by a dotted arrow in FIG. 6. When the switching transistor G7 is turned on, the current flows out from the positive terminal of the high-voltage power battery, passes through the PTC power distribution connector, the heating resistor connector and one end of the heating resistor, flows through the switching transistor G7 and the voltage-dividing resistor R3 of the heating controller, and finally flows to the negative terminal of the high-voltage power battery. In this process, if the circuit connection is complete, the current flows through the voltage-dividing resistor R3, so the sampling voltage U3 can be detected.

Step S302: determining whether a high-voltage interlock fault has occurred in a phase corresponding to each of the second voltage-dividing resistors according to a comparison result between a third voltage applied across the second voltage-dividing resistor and the voltage threshold, wherein the phase corresponding to the second voltage-dividing resistor is one phase of the heating resistor.

Step S303: when the third voltage is less than the voltage threshold, determining that a high-voltage interlock fault has occurred in the phase corresponding to the second voltage-dividing resistor.

The phase corresponding to the second voltage-dividing resistor can represent one phase of the heating resistor. That is, the heating resistor can be a three-phase heating resistor.

For each second voltage-dividing resistor, the corresponding voltage can be collected. Then, the voltage of each second voltage-dividing resistor is compared with the voltage threshold to obtain a comparison result. Whether a high-voltage interlock fault has occurred in the phase corresponding to the second voltage-dividing resistor can be accurately determined according to the comparison result. When the third voltage corresponding to the second voltage-dividing resistor is less than the voltage threshold, it is determined that a high-voltage interlock fault has occurred in the phase corresponding to the second voltage-dividing resistor; and when the third voltage corresponding to the second voltage-dividing resistor is not less than the voltage threshold, it is determined that no high-voltage interlock fault has occurred in the phase corresponding to the second voltage-dividing resistor.

In a possible implementation, multiplexed detection can also be adopted for the heating resistor. That is, when the third voltage corresponding to the second voltage-dividing resistor is less than the voltage threshold, each switching transistor in the second switching transistor array of the heating controller is controlled again to be turned on, such that a fourth voltage is applied across each second voltage-dividing resistor to detect high-voltage interlock faults. Then, when both the third voltage and the fourth voltage are less than the voltage threshold, it is determined that a high-voltage interlock fault has occurred in the phase corresponding to the second voltage-dividing resistor.

In a possible implementation, the second switching transistor array includes at least two switching transistors. The controlling each switching transistor in the second switching transistor array of the heating controller to be turned on in the above step S301 includes: controlling at least two switching transistors of the heating controller to be turned on at a second moment, wherein the second switching transistor array and the at least two switching transistors are both configured to detect high-voltage interlock faults.

At least two switching transistors of the heating controller and the bridge leg switching transistor of the air conditioning compressor motor are turned on at the same moment, both being the second moment, wherein the at least two switching transistors are configured to detect high-voltage interlock faults, and the bridge leg switching transistor is configured to detect high-voltage interlock faults and is connected to the first voltage-dividing resistor. When the current time reaches the second moment, the at least two switching transistors of the heating controller are controlled to be turned on, wherein the at least two switching transistors are configured to detect high-voltage interlock faults.

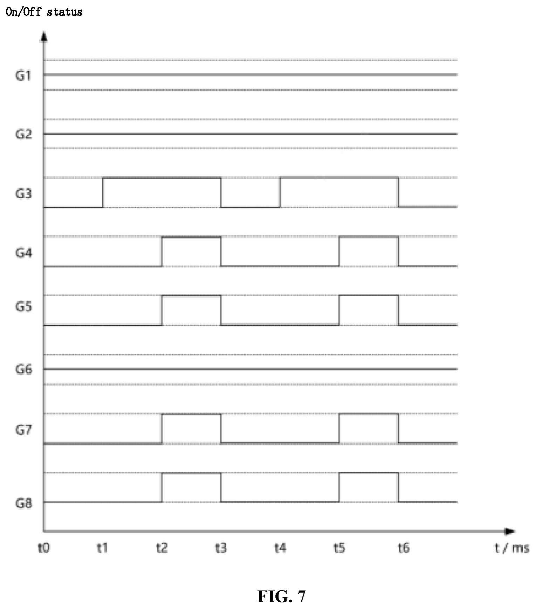

Please refer to FIG. 7 which is a timing diagram of the conduction of a switching transistor configured to detect high-voltage interlock faults provided according to an embodiment of the present invention.

When the entire vehicle is powered on with high voltage at time t0, at time t1, the air conditioning controller controls the switching transistor G3 of a U-phase upper bridge leg to be turned on. At time t2, the air conditioning controller controls the switching transistor G4 of a W-phase lower bridge leg and the switching transistor G5 of a V-phase lower bridge leg to be turned on. Synchronously, at time t2, the heating controller controls the switching transistor G7 and the switching transistor G8 to be turned on and controls the remaining switching transistors to remain a disconnected state. From time t2 to time t3, the sampling voltage U1 across the W-phase voltage-dividing resistor R1 and the sampling voltage U2 across the V-phase voltage-dividing resistor R2 are collected. At time t3, all the switching transistors are turned off.

From time t2 to time t3, the current flows out from the positive terminal of the high-voltage power battery, passes through the switching transistor G1 of the air conditioning controller, flows through the ACP power distribution connector, the air conditioning compressor connector, and the U phase of the air conditioning motor. Then, after flowing through the U phase and V phase of the air conditioning motor respectively, the current flows through the switching transistor G4 and the voltage-dividing resistor R1 of the air conditioning controller, as well as the switching transistor G5 and the voltage-dividing resistor R2 of the air conditioning controller respectively, and finally flows to the negative terminal of the high-voltage power battery.

From time t2 to time t3, the current flows out from the positive terminal of the high-voltage power battery, passes through the PTC power distribution connector, the heating resistor connector, and one end of the heating resistor. Then, after respectively flowing through the two heating resistors of the heating resistor, the current then respectively flows through the switching transistor G7 and the voltage-dividing resistor R3 of the heating controller, as well as the switching transistor G8 and the voltage-dividing resistor R4 of the heating controller, and finally flows to the negative terminal of the high-voltage power battery. In this process, if the circuit connection is complete, the current flows through both the voltage-dividing resistor R3 and the voltage-dividing resistor R4. Therefore, it can be detected that the values of the sampling voltage U3 and the sampling voltage U4 are not less than the voltage threshold.

From time t3 to time t6, the opening and closing states of all the switching transistors are repeatedly detected according to the timing sequence from time t0 to time t3, so as to ensure the accuracy of the detection results and reduce the probability of false alarms for high-voltage interlock faults.

More specifically, if it is detected that the values of the sampling voltage U1 and the sampling voltage U2 are not less than the voltage threshold, it is determined that the ACP power distribution connector and the air-conditioning compressor connector are completely connected; if it is detected twice that the sampling voltage U1 is less than the voltage threshold or the value of the sampling voltage U2 is less than the set threshold, it is determined that a high-voltage interlock fault has occurred in the W-phase or V-phase circuit of the air-conditioning compressor, and fault location of a high-voltage interlock loop is carried out according to a detection result. After the detection is completed, all the switching transistors are turned off.

Similarly, if it is detected that the values of the sampling voltage U3 and the sampling voltage U4 are greater than or equal to the voltage threshold, it is determined that the PTC power distribution connector and the heating resistor connector are completely connected; if it is detected twice that the sampling voltage U3 is less than the voltage threshold or the value of the sampling voltage U4 is less than the voltage threshold, it is determined that a high-voltage interlock fault has occurred in the heating resistor circuit, and fault location of the high-voltage interlock loop is carried out according to the detection result. After the detection is completed, all the switching transistors are turned off.

In the method for detecting high-voltage interlock faults provided in this embodiment, each switching transistor in the second switching transistor array of the heating controller is controlled to be turned on, then the third voltage applied across each second voltage-dividing resistor is collected, and the third voltage applied across each second voltage-dividing resistor is compared with the voltage threshold to determine a comparison result corresponding to each first voltage-dividing resistor, and whether a high-voltage interlock fault has occurred in the motor phase corresponding to each first voltage-dividing resistor can be accurately determined according to the comparison result corresponding to each first voltage-dividing resistor.

In a possible implementation, in order to accurately handle with high-voltage interlock faults, the above method further includes:
Step S401: when a high-voltage interlock fault has occurred in a target phase, obtaining a specific location of the high-voltage interlock fault, wherein the target phase includes the motor phase corresponding to the first voltage-dividing resistor and/or the phase corresponding to the second voltage-dividing resistor.

The target phase may include the motor phase corresponding to the first voltage-dividing resistor and/or the phase corresponding to the second voltage-dividing resistor. The occurrence of a high-voltage interlock fault in the target phase may indicate that a high-voltage interlock fault has occurred in the motor phase corresponding to the first voltage-dividing resistor, a high-voltage interlock fault has occurred in the phase corresponding to the second voltage-dividing resistor, or faults have occurred in both the motor phase corresponding to the first voltage-dividing resistor and the phase corresponding to the second voltage-dividing resistor.

During specific implementation, when a high-voltage interlock fault has occurred in the target phase, the high-voltage interlock fault location can be determined according to an AC circuit and a PTC circuit in the air conditioning control system.

Step S402: determining a high-voltage interlock fault handling strategy corresponding to the high-voltage interlock fault location based on the high-voltage interlock fault location.

Specifically, the above step S402 includes:
Step S4021: if the high-voltage interlock fault location is the motor phase corresponding to the first voltage-dividing resistor, the determining the high-voltage interlock fault handling strategy corresponding to the motor phase includes: controlling a high-voltage system of an entire vehicle to be powered on, turning off each switching transistor of the three-phase bridge legs of the air conditioning controller, limiting the power of the air conditioning controller to a first preset value, controlling a system fault indicator light of a first target color on an instrument panel to be turned on, and controlling a display module to give a first text reminder.

The first preset value can represent the power value of the air conditioning controller. The first preset value can be zero or other values, which is not specifically limited herein. The first target color can be yellow, blue, etc., which is not specifically limited herein. The display module can be a central control screen of a target vehicle or other devices of the target vehicle used for displaying text, which is not specifically limited herein.

During specific implementation, if the high-voltage interlock fault location is the motor phase corresponding to the first voltage-dividing resistor, it is necessary to control a high-voltage system of an entire vehicle to be powered on, turn off each switching transistor of the three-phase bridge legs of the air conditioning controller, limit the power of the air conditioning controller to a first preset value, control a system fault indicator light of a first target color on an instrument panel to be turned on, and control a display module to give a first text reminder.

For example, when a high-voltage interlock fault has occurred in the motor phase corresponding to the first voltage-dividing resistor, a high-voltage system of an entire vehicle is controlled to be powered on, each switching transistor of the three-phase bridge legs of the air conditioning controller is turned off, the power of the air conditioning controller is limited to a first preset value, a yellow system fault indicator light on an instrument panel is controlled to be turned on, and a display module is controlled to give a first text reminder. For example: "For high-voltage interlock faults, please go to a 4S store for maintenance."

Step S4022: if the high-voltage interlock fault location is the phase corresponding to the second voltage-dividing resistor, the determining the high-voltage interlock fault handling strategy corresponding to the target phase includes: controlling a high-voltage system of an entire vehicle to be powered on, turning off each switching transistor of the heating controller, limiting the power of the heating controller to a second preset value, controlling a system fault indicator light of a second target color on an instrument panel to be turned on, and controlling the display module to give a second text reminder.

The second preset value can represent the power value of the heating resistor. The second preset value can be zero or other values, which is not specifically limited herein. The second target color can be yellow, blue, etc., which is not limited herein. The display module can be a central control screen of a target vehicle or other devices of the target vehicle for displaying text, which is not specifically limited herein.

During specific implementation, if the high-voltage interlock fault location is the phase corresponding to the second voltage-dividing resistor, it is necessary to control a high-voltage system of an entire vehicle to be powered on, turn off each switching transistor of the heating controller, limit the power of the air conditioning controller to a second preset value, control a system fault indicator light of a second target color on an instrument panel to be turned on, and control a display module to give a second text reminder. For example: "For high-voltage interlock faults, please go to a 4S store for maintenance."

In traditional solutions, when a high-voltage interlock fault occurs, the entire vehicle needs to be powered off according to a vehicle usage scenario, and the vehicle even cannot be powered on for driving after power-off. In contrast, the method for detecting high-voltage interlock faults provided in this embodiment ensures that the occurrence of an interlock fault will not affect high-voltage power-on or power-off operations or driving functionality of the entire vehicle. By simply turning off the switching transistors, it is guaranteed that connector ports remain de-energized. This method maintains personnel safety without compromising vehicle operation, thereby significantly enhancing the driving experience after a fault occurs.

In a possible implementation, the above method further includes:
Step S501: determining the high-voltage interlock fault handling strategy corresponding to the vehicle status of a target vehicle based on the vehicle status of the target vehicle.

The vehicle status of the target vehicle can represent a power-on state, a power-off state, etc. When a high-voltage interlock fault has occurred in at least one motor phase, it indicates that there is a problem with the vehicle. In this case, the vehicle status of the target vehicle needs to be obtained, and the high-voltage interlock fault handling strategy should be determined according to the vehicle status of the target vehicle.

Step S502: determining the high-voltage interlock fault handling strategy corresponding to the vehicle status of the target vehicle based on the vehicle status of the target vehicle.

Specifically, the above step S502 includes:
Step S5021: if the vehicle status of the target vehicle is a power-off state, detecting whether the target vehicle is powered on with high voltage.
Step S5022: if the target vehicle is not powered on with high voltage, controlling a red system fault indicator light on a display module to be turned on, and controlling the display module to give a text reminder.

If the air conditioning control module reports a high-voltage interlock fault and the vehicle status of the target vehicle is in a power-off state, whether the entire vehicle is powered on with high voltage is further confirmed. If the entire vehicle is not powered on with high voltage, then the entire vehicle is prevented from being powered on with high voltage, the red system fault indicator light on the instrument panel is turned on, and a text reminder is given on the instrument panel to inform the user that "for high-voltage interlock faults, please go to a 4S store for maintenance".

Step S5023: if the target vehicle is powered on with high voltage, controlling the target vehicle to be powered off from high voltage, controlling the red system fault indicator light on the display module to be turned on, and controlling the display module to give a text reminder.

If the air conditioning control module reports a high-voltage interlock fault and the vehicle status of the target vehicle is a power-off state, whether the entire vehicle is powered on with high voltage is further confirmed. If the entire vehicle is powered on with high voltage, then the entire vehicle should be powered off from high voltage, the red system fault indicator light on the instrument panel is turned on, and a text reminder is given on the instrument panel to inform the user that "for high-voltage interlock faults, please go to a 4S store for maintenance".

Step S5024: if the vehicle status of the target vehicle is a power-on state, controlling the yellow system fault indicator light on the display module to be turned on, and controlling the display module to give a text reminder.

If the air conditioning control module reports a high-voltage interlock fault and the current vehicle status is a power-on state, whether the entire vehicle is powered on with high voltage is further confirmed. If the vehicle has been powered on with high voltage, the entire vehicle will be powered off from high voltage, the red system fault indicator light on the instrument panel is turned on, and a text reminder is given on the instrument panel to inform the user that "for high-voltage interlock faults, please go to a 4S store for maintenance."

Step S5025: if the vehicle status of the target vehicle changes from a power-on state to a power-off state, controlling the red system fault indicator light on the display module to be turned on, and controlling the display module to give a text reminder.

If the air conditioning control module reports a high-voltage interlock fault and the current vehicle status is a power-on state, the entire vehicle will not be powered off from high voltage. The yellow system fault indicator light on the instrument panel is turned on, and a text reminder is given on the instrument panel to inform the user that "for high-voltage interlock faults, please go to a 4S store for maintenance." The vehicle status is continuously monitored. If the operation of the user causes the entire vehicle to return to a power-off state, the post-fault processing is performed according to the above step S5023.

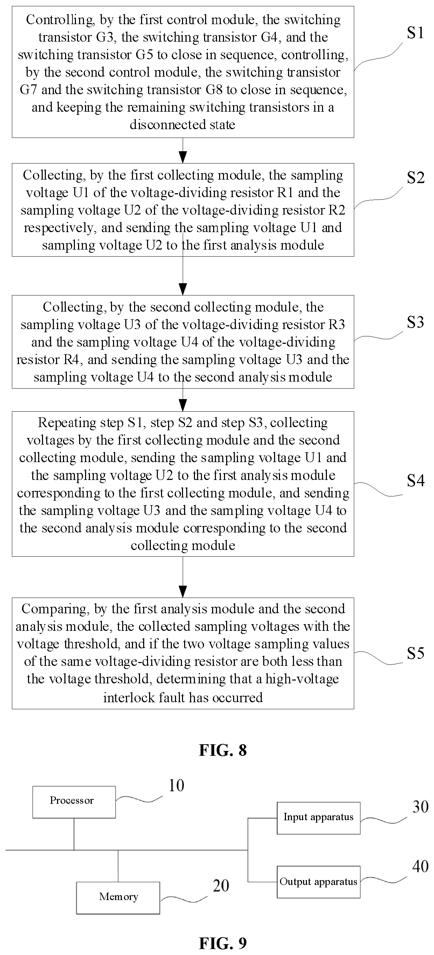

Please refer to FIG. 8 which is a flow diagram of another method for detecting high-voltage interlock faults provided according to an embodiment of the present invention.

The air conditioning controller includes a first control module, a second control module, a first collecting module, a second collecting module, a first analysis module, a second analysis module, a first processing module, and a second processing module.

Step S1: controlling, by the first control module, the switching transistor G3, the switching transistor G4, and the switching transistor G5 to close in sequence, controlling, by the second control module, the switching transistor G7 and the switching transistor G8 to close in sequence, and keeping the remaining switching transistors in a disconnected state.

Step S2: collecting, by the first collecting module, the sampling voltage U1 of the voltage-dividing resistor R1 and the sampling voltage U2 of the voltage-dividing resistor R2 respectively, and sending the sampling voltage U1 and sampling voltage U2 to the first analysis module.

Step S3: collecting, by the second collecting module, the sampling voltage U3 of the voltage-dividing resistor R3 and the sampling voltage U4 of the voltage-dividing resistor R4, and sending the sampling voltage U3 and the sampling voltage U4 to the second analysis module.

Step S4: repeating step S1, step S2 and step S3, collecting voltages by the first collecting module and the second collecting module, sending the sampling voltage U1 and the sampling voltage U2 to the first analysis module corresponding to the first collecting module, and sending the sampling voltage U3 and the sampling voltage U4 to the second analysis module corresponding to the second collecting module.

Step S5: comparing, by the first analysis module and the second analysis module, the collected sampling voltages with the voltage threshold, and if the two voltage sampling values of the same voltage-dividing resistor are both less than the voltage threshold, determining that a high-voltage interlock fault has occurred.

In the method for detecting high-voltage interlock faults provided in this embodiment, the connection status of high-voltage connectors is monitored through a software interlock detection circuit in the air conditioning control module, thereby avoiding the problem of false alarms of high-voltage interlock faults by the entire vehicle caused by failures of low-voltage hard-wired interlock terminals or momentary interruptions of high-voltage interlock signals due to large vibrations of the vehicle, reducing the failure rate of high-voltage interlock detection, and improving the robustness of high-voltage interlock detection. The method further avoids the problem of EMC interference coupling in a control board circuit caused by using low-voltage hard-wired interlock lines, and avoids an increase in the costs of low-voltage wiring harnesses, low-voltage connectors, or detection chips caused by using hard-wired interlock lines, thereby reducing the system costs.

In addition, the switching transistors in the air conditioning control module product are multiplexed, the opening and closing of the corresponding switching transistors is controlled according to a timing sequence, and then the connection status of the two connectors on the circuit and the integrity of the entire circuit are simultaneously monitored through the bus voltage and the detected voltage values across the sampling resistor, and a plurality of re-inspections should be performed on the high-voltage circuit to ensure the reliability of the detection. The system of the present invention has a high degree of integration and a wider detection range, and the detection results are highly reliable and robust, thereby significantly reducing the cost of high-voltage interlock detection.

In addition, the handling strategies for high-voltage interlock and insulation faults are further optimized. Based on the analysis of vehicle usage scenarios, on the premise of ensuring personnel safety to the greatest extent, the vehicle usage experience when a high-voltage interlock fault occurs is improved.

In the embodiments of the present invention, an apparatus for detecting high-voltage interlock faults is also provided. The apparatus is configured to implement the above method embodiments and preferred embodiments, and the content that has been described will not be repeated. As used hereinafter, the term "unit" may refer to a combination of software and/or hardware that can implement a predetermined function. Although the apparatus described in the following embodiments is preferably implemented in software, the implementation in hardware or a combination of software and hardware is also possible and contemplated. The apparatus in the embodiments of the present invention is presented in the form of functional units. The functional unit herein refers to an ASIC (Application Specific Integrated Circuit), a processor and a memory that execute one or more software or fixed programs, and/or other devices that can provide the above functions.

This apparatus is applied to an air conditioning control system. The air conditioning control system includes an air conditioning controller and an air conditioning compressor motor; a midpoint of each phase bridge leg in the three-phase bridge legs of the air conditioning controller is respectively connected to a different phase of the air conditioning compressor motor; each phase bridge leg respectively includes an upper bridge leg switching transistor and a lower bridge leg switching transistor. The apparatus includes:

a switching transistor control module configured to control each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and each of the first voltage-dividing resistors is connected to a different bridge leg switching transistor in the first switching transistor array; and a fault determination module configured to determine whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

In a possible implementation, the above fault determination module is further configured to determine that a high-voltage interlock fault has occurred in the motor phase corresponding to the first voltage-dividing resistor when the first voltage of the first voltage-dividing resistor is less than the voltage threshold.

In a possible implementation, the above fault determination module is further configured to: when the first voltage applied across the first voltage-dividing resistor is less than the voltage threshold, control again each bridge leg switching transistor in the first switching transistor array in the three-phase bridge legs of the air conditioning controller to be turned on, such that a second voltage is applied across each of the first voltage-dividing resistors; when both the first voltage of the first voltage-dividing resistor and the second voltage of the first voltage-dividing resistor are less than the voltage threshold, determine that a high-voltage interlock fault has occurred in the motor phase corresponding to the first voltage-dividing resistor; and when the first voltage is less than the voltage threshold and the second voltage is not less than the voltage threshold, determine that no high-voltage interlock fault has occurred in the motor phase corresponding to the first voltage-dividing resistor.

In a possible implementation, the switching transistor control module is further configured to: control the bridge leg switching transistors in the first switching transistor array that are not connected to the first voltage-dividing resistor to be turned on at the first moment; and control the bridge leg switching transistors in the first switching transistor array that are connected to the first voltage-dividing resistor to be turned on at the second moment.

In a possible implementation, the air conditioning control system further includes a heating controller and a heating resistor, and the above apparatus further includes:
a heating controller control module configured to control each switching transistor in a second switching transistor array of the heating controller to be turned on, such that a third voltage is applied across each second voltage-dividing resistor, wherein each of the second voltage-dividing resistors is connected to a different switching transistor in the second switching transistor array; a first heating controller determination module configured to determine whether a high-voltage interlock fault has occurred in a phase corresponding to each of the second voltage-dividing resistors according to a comparison result between the third voltage and the voltage threshold, wherein the phase corresponding to the second voltage-dividing resistor is one phase of the heating resistor; and a second heating controller determination module configured to: when the third voltage is less than the voltage threshold, determine that a high-voltage interlock fault has occurred in the phase corresponding to the second voltage-dividing resistor.

In a possible implementation, the second switching transistor array includes at least two switching transistors. The heating controller control module is further configured to control at least two switching transistors of the heating controller to be turned on at the second moment.

In a possible implementation, the above apparatus further includes: an acquisition module configured to: when a high-voltage interlock fault has occurred in a target phase, obtain a specific location of the high-voltage interlock fault, wherein the target phase includes the motor phase corresponding to the first voltage-dividing resistor and/or the phase corresponding to the second voltage-dividing resistor; and a processing strategy determination module configured to determine the high-voltage interlock fault processing strategy corresponding to the high-voltage interlock fault location based on the high-voltage interlock fault location.

In a possible implementation, the processing strategy determination module is further configured to: if the high-voltage interlock fault location is the motor phase corresponding to the first voltage-dividing resistor, the determining the high-voltage interlock fault handling strategy corresponding to the motor phase includes: controlling a high-voltage system of an entire vehicle to be powered on, turning off each switching transistor of the three-phase bridge legs of the air conditioning controller, limiting the power of the air conditioning controller to a first preset value, controlling a system fault indicator light of a first target color on an instrument panel to be turned on, and controlling a display module to give a first text reminder; and if the high-voltage interlock fault location is the phase corresponding to the second voltage-dividing resistor, the determining the high-voltage interlock fault handling strategy corresponding to the target phase includes: controlling a high-voltage system of an entire vehicle to be powered on, turning off each switching transistor of the heating controller, limiting the power of the heating controller to a second preset value, controlling a system fault indicator light of a second target color on an instrument panel to be turned on, and controlling a display module to give a second text reminder.

In a possible implementation, the processing strategy determination module is further configured to: if the vehicle status of the target vehicle is a power-on state, control the yellow system fault indicator light on the display module to be turned on and control the display module to give a text reminder; if the vehicle status of the target vehicle changes from a power-on state to a power-off state, control the red system fault indicator light on the display module to be turned on and control the display module to give a text reminder.

Referring to FIG. 9, FIG. 9 is a schematic diagram of a hardware structure of a computer device provided by an embodiment of the present invention. The computer device includes: one or more processors 10, a memory 20, and interfaces for connecting various components, and the interfaces include high-speed interfaces and low-speed interfaces. Various components are communicatively connected with each other through different buses and can be installed on a common motherboard or in other ways as required. The processor can process instructions executed within the computer device, and the instructions include instructions stored in or on a memory to display graphical information of a GUI (Graphical User Interface) on an external input/output apparatus, such as a display device coupled to an interface. In some optional embodiments, if necessary, a plurality of processors and/or a plurality of buses can be used together with a plurality of memories. Similarly, a plurality of vehicles can be connected, and each device provides some necessary operations (for example, as a server array, a group of blade servers, or a multi-processor system). The processor 10 can be a central processing unit, a network processor, or a combination thereof. The processor 10 may further include a hardware chip. The above hardware chip can be an application-specific integrated circuit, a programmable logic device, or a combination thereof. The above programmable logic device can be a complex programmable logic device, a field-programmable gate array, a generic array logic, or any combination thereof. The memory 20 stores instructions executable by at least one processor 10, such that at least one processor 10 can execute the method shown in the above embodiments. The memory 20 can include a program storage area and a data storage area. The program storage area can store an operating system and applications required for at least one function; and the data storage area can store data created according to the use of the vehicle, etc. In addition, the memory 20 can include a high-speed random-access memory and can also include a non-transitory memory, such as at least one disc storage device, a flash memory device, or other non-transitory solid-state storage devices. In some optional embodiments, the memory 20 can optionally include memories remotely set relative to the processor 10, and these remote memories can be connected to the computer device through a network. Examples of the above network include but are not limited to the Internet, an intranet, a local area network, a mobile communication network, and combinations thereof. The memory 20 can include a volatile memory, such as a random-access memory; the memory can also include a nonvolatile memory, such as a flash memory, a hard disc, or a solid-state drive; the memory 20 can also include a combination of the above types of memories. The computer device also includes an input apparatus 30 and an output apparatus 40. The processor 10, the memory 20, the input apparatus 30, and the output apparatus 40 can be connected through a bus or in other ways. The input apparatus 30 can receive input digital or character information and generate key signal inputs related to user settings and function control of the computer device, such as a touch screen, a keypad, a mouse, a trackpad, a touchpad, a pointing stick, one or more mouse buttons, a trackball, a joystick, etc. The output apparatus 40 can include a display device, an auxiliary lighting device (such as an LED), a tactile feedback device (such as a vibration motor), etc. The above display device includes but is not limited to a liquid crystal display, a light-emitting diode, a monitor, and a plasma display. In some optional embodiments, the display device can be a touch screen.

Embodiments of the present invention also provide a computer-readable storage medium. The method according to the embodiments of the present invention can be implemented in hardware or firmware, or can be implemented as computer code that can be recorded in a storage medium, or can be implemented as computer code that is originally stored in a remote storage medium or a non-transitory machine-readable storage medium via network download and will be stored in a local storage medium. Therefore, the method described herein can be processed by such software stored on a storage medium using a general-purpose computer, a dedicated processor, or programmable or dedicated hardware. The storage medium can be a magnetic disc, an optical disc, a read-only memory, a random-access memory, a flash memory, a hard disc, a solid-state drive, etc. Further, the storage medium can also include a combination of the above types of memories. It can be understood that a computer, a processor, a microprocessor controller, or programmable hardware includes a storage component that can store or receive software or computer code. When the software or computer code is accessed and executed by the computer, the processor, or the hardware, the methods shown in the above embodiments are implemented.

A part of the embodiments of the present invention can be applied as a computer program product, such as computer program instructions. When executed by a computer, through the operations of the computer, the methods and/or technical solutions according to the present invention can be invoked or provided. Those skilled in the art should understand that the forms in which computer program instructions exist in a computer-readable medium include but are not limited to source files, executable files, installation package files, etc. Correspondingly, the ways in which computer program instructions are executed by a computer include but are not limited to: the computer directly executes the instructions, or the computer compiles the instructions and then executes the corresponding compiled program, or the computer reads and executes the instructions, or the computer reads and installs the instructions and then executes the corresponding installed program. The computer-readable medium herein can be any available computer-readable storage medium or communication medium accessible to the computer.

The above embodiments are merely preferred embodiments provided to fully illustrate the present invention, and the protection scope of the present invention is not limited thereto. Any equivalent substitutions or alterations made by those skilled in the art on the basis of the present invention shall fall within the protection scope of the present invention.

## Claims

1. A method for detecting high-voltage interlock faults, **characterized in that** the method is applied to an air conditioning control system; the air conditioning control system comprises an air conditioning controller and an air conditioning compressor motor; a midpoint of each phase bridge leg in three-phase bridge legs of the air conditioning controller is respectively connected to a different phase of the air conditioning compressor motor; each phase bridge leg includes an upper bridge leg switching transistor and a lower bridge leg switching transistor; and the method comprising:
controlling each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and each of the first voltage-dividing resistors is connected to a different bridge leg switching transistor in the first switching transistor array; and
determining whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

2. The method for detecting high-voltage interlock faults according to claim 1, **characterized in that** the determining whether a high-voltage interlock fault has occurred in a motor phase corresponding to each of the first voltage-dividing resistors according to a comparison result between the first voltage and a voltage threshold comprises:
when the first voltage applied across the first voltage-dividing resistor is less than the voltage threshold, determining that a high-voltage interlock fault has occurred in the motor phase corresponding to the first voltage-dividing resistor.

3. The method for detecting high-voltage interlock faults according to claim 1, **characterized in that** the determining whether a high-voltage interlock fault has occurred in a motor phase corresponding to each of the first voltage-dividing resistors according to a comparison result between the first voltage and a voltage threshold comprises:
when the first voltage applied across the first voltage-dividing resistor is less than the voltage threshold, controlling again each bridge leg switching transistor in the first switching transistor array in the three-phase bridge legs of the air conditioning controller to be turned on, such that a second voltage is applied across each of the first voltage-dividing resistors to detect the high-voltage interlock faults;
when both the first voltage and the second voltage are less than the voltage threshold, determining that a high-voltage interlock fault has occurred in the motor phase corresponding to the first voltage-dividing resistor; and
when the first voltage is less than the voltage threshold and the second voltage is not less than the voltage threshold, determining that no high-voltage interlock fault has occurred in the motor phase corresponding to the first voltage-dividing resistor.

4. The method for detecting high-voltage interlock faults according to claim 1, **characterized in that** the controlling each bridge leg switching transistor in a first switching transistor array in the three-phase bridge legs of the air conditioning controller to be turned on comprises:
at a first moment, controlling the bridge leg switching transistors in the first switching transistor array that are not connected to the first voltage-dividing resistor to be turned on; and
at a second moment, controlling the bridge leg switching transistors in the first switching transistor array that are connected to the first voltage-dividing resistor to be turned on.

5. The method for detecting high-voltage interlock faults according to claim 1, **characterized in that** the air conditioning control system further comprises a heating controller and a heating resistor; and the method further comprises:
controlling each switching transistor in a second switching transistor array of the heating controller to be turned on, wherein each switching transistor in the second switching transistor array is configured to detect high-voltage interlock faults, such that a third voltage is applied across each second voltage-dividing resistor to detect high-voltage interlock faults, wherein each of the second voltage-dividing resistors is connected to a different switching transistor in the second switching transistor array;
determining whether a high-voltage interlock fault has occurred in a phase corresponding to each of the second voltage-dividing resistors according to a comparison result between a third voltage applied across the second voltage-dividing resistor and the voltage threshold, wherein the phase corresponding to the second voltage-dividing resistor is one phase of the heating resistor; and
when the third voltage is less than the voltage threshold, determining that a high-voltage interlock fault has occurred in the phase corresponding to the second voltage-dividing resistor.

6. The method for detecting high-voltage interlock faults according to claim 5, **characterized in that** the second switching transistor array comprises at least two switching transistors, and the controlling each switching transistor in the second switching transistor array of the heating controller to be turned on comprises:
at the second moment, controlling at least two switching transistors of the heating controller to be turned on, wherein the at least two switching transistors are configured to detect high-voltage interlock faults.

7. The method for detecting high-voltage interlock faults according to claim 5, **characterized in that** the method further comprises:
when a high-voltage interlock fault has occurred in a target phase, obtaining a specific location of the high-voltage interlock fault, wherein the target phase comprises the motor phase corresponding to the first voltage-dividing resistor and/or the phase corresponding to the second voltage-dividing resistor; and
determining a high-voltage interlock fault handling strategy corresponding to the high-voltage interlock fault location based on the high-voltage interlock fault location.

8. The method for detecting high-voltage interlock faults according to claim 7, **characterized in that** the determining a high-voltage interlock fault handling strategy corresponding to the high-voltage interlock fault location based on the high-voltage interlock fault location comprises:
if the high-voltage interlock fault location is the motor phase corresponding to the first voltage-dividing resistor, the determining the high-voltage interlock fault handling strategy corresponding to the motor phase comprises: controlling a high-voltage system of an entire vehicle to be powered on, turning off each switching transistor of the three-phase bridge legs of the air conditioning controller, limiting the power of the air conditioning controller to a first preset value, controlling a system fault indicator light of a first target color on an instrument panel to be turned on, and controlling a display module to give a first text reminder; and
if the high-voltage interlock fault location is the phase corresponding to the second voltage-dividing resistor, the determining the high-voltage interlock fault handling strategy corresponding to the target phase comprises: controlling a high-voltage system of an entire vehicle to be powered on, turning off each switching transistor of the heating controller, limiting the power of the heating controller to a second preset value, controlling a system fault indicator light of a second target color on an instrument panel to be turned on, and controlling the display module to give a second text reminder.

9. An apparatus for detecting high-voltage interlock faults, **characterized in that** the apparatus is applied to an air conditioning control system; the air conditioning control system comprises an air conditioning controller and an air conditioning compressor motor; a midpoint of each phase bridge leg in the three-phase bridge legs of the air conditioning controller is respectively connected to a different phase of the air conditioning compressor motor; each phase bridge leg includes an upper bridge leg switching transistor and a lower bridge leg switching transistor; and the apparatus comprises:
a switching transistor control module configured to control each bridge leg switching transistor in a first switching transistor array in the three-phase bridge legs of the air conditioning controller to be turned on, wherein each bridge leg switching transistor in the first switching transistor array is configured to detect high-voltage interlock faults, such that a first voltage is applied across each first voltage-dividing resistor to detect high-voltage interlock faults; and each of the first voltage-dividing resistors is connected to a different bridge leg switching transistor in the first switching transistor array; and
a fault determination module configured to determine whether a high-voltage interlock fault has occurred in a motor phase corresponding to each of the first voltage-dividing resistors according to a comparison result between the first voltage and a voltage threshold, wherein the motor phase corresponding to the first voltage-dividing resistor is one phase of the air conditioning compressor motor.

10. A vehicle, comprising:
a memory and a processor, wherein the memory and the processor are communicatively connected to each other; computer instructions are stored in the memory; and the processor executes the method for detecting high-voltage interlock faults in any one of claims 1 to 8 by executing the computer instructions.

11. A computer-readable storage medium, **characterized in that** computer instructions are stored on the computer-readable storage medium, and the computer instructions are used to enable a computer to execute the method for detecting high-voltage interlock faults according to any one of claims 1 to 8.

12. A computer program product, comprising computer instructions, **characterized in that** the computer instructions are used to enable a computer to execute the method for detecting high-voltage interlock faults according to any one of claims 1 to 8.
